Europäisches Patentamt

European Patent Office

Office européen des brevets

(11) Numéro de publication : **0 142 450**
**B1**

(12) **FASCICULE DE BREVET EUROPÉEN**

(45) Date de publication du fascicule du brevet :
28.09.88

(51) Int. Cl.⁴ : **H 01 J 37/32, C 23 C 16/50**

(21) Numéro de dépôt : **84402319.2**

(22) Date de dépôt : **14.11.84**

(54) **Dispositif pour la réalisation de couches diélectriques minces à la surface de corps solides.**

(30) Priorité : **17.11.83 FR 8318299**

(43) Date de publication de la demande :
**22.05.85 Bulletin 85/21**

(45) Mention de la délivrance du brevet :
**28.09.88 Bulletin 88/39**

(84) Etats contractants désignés :
**DE GB IT NL**

(56) Documents cités :
**EP-A- 0 039 406**
**FR-A- 2 355 377**
**FR-A- 2 455 364**
**JOURNAL OF APPLIED PHYSICS, volume 38, no. 11, octobre 1967, pages 4323-4330, New York, US; J. KRAITCHMAN: "Silicon oxide films grown in a micro-wave discharge"**

(73) Titulaire : **Berenguer, Marc**
**101 Avenue A. Briand**
**F-38600 Fontaine (FR)**

**Straboni, Alain**
**18, rue Condorcet**
**F-38000 Grenoble (FR)**

**Vuillermoz, Bernard**
**22, Boulevard Maréchal Leclerc**
**F-38000 Grenoble (FR)**

(72) Inventeur : **Berenguer, Marc**
**101 Avenue A. Briand**
**F-38600 Fontaine (FR)**
Inventeur : **Straboni, Alain**
**18, rue Condorcet**
**F-38000 Grenoble (FR)**
Inventeur : **Vuillermoz, Bernard**
**22, Boulevard Maréchal Leclerc**
**F-38000 Grenoble (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Description

La présente invention a pour objet un dispositif pour la réalisation de couches diélectriques minces à la surface de corps solides, notamment pour l'oxydation ou la nitruration de plaquettes de silicium utilisées dans la fabrication des circuits intégrés.

L'oxydation de substrats tels que des semiconducteurs a été d'abord réalisée par voie thermique en atmosphère d'oxygène sèche ou humide à des températures de l'ordre de 800 à 1100 °C. Cependant, avec le développement de la microminiaturisation, les procédés d'oxydation thermique deviennent de plus en plus difficiles à employer à cause des températures élevées qui sont nécessaires en raison des structures complexes. En effet, la distribution des impuretés change beaucoup à haute température. C'est pourquoi des efforts ont été faits pour trouver des procédés d'oxydation permettant de travailler à des températures plus basses, de l'ordre de 700 °C et de préférence en-dessous, températures auxquelles les coefficients de diffusion des impuretés deviennent très faibles, et les déformations consécutives aux contraintes mécaniques sont minimisées. C'est ainsi qu'on a développé des techniques d'oxydation permettant d'activer les réactions chimiques par plasma.

Le brevet européen 0039406 décrit un procédé d'oxydation qui consiste à placer le substrat à oxyder à l'intérieur d'un tube étanche de forme allongée parcouru par un courant d'oxygène et équipé de moyens de création et d'excitation du plasma à l'une de ses extrémités, l'échantillon à traiter étant une plaquette disposée perpendiculairement au courant de plasma et proche de la zone de création de celui-ci. Dans une variante, il est possible de traiter plusieurs plaquettes simultanément, mais les plaquettes se trouvent dans un même plan transversal du tube.

Cet appareil présente un certain nombre d'inconvénients dont le principal est qu'il est difficile de maîtriser la croissance de l'oxyde et par conséquent son épaisseur et sa régularité sur toute la face de la plaquette. D'autre part, ce dispositif ne fonctionne que si la plaquette est relativement près de la zone d'excitation du plasma : en effet, la plaquette obture en grande partie le tube et crée une différence de certains paramètres du plasma, ce qui provoque l'oxydation de sa face située en aval par rapport au courant d'oxygène. Or, le fait que la plaquette à oxyder se trouve près de la zone d'excitation du plasma entraîne une possibilité de déposition sur la plaquette de particules oxydées provenant du tube lui-même au niveau de la zone d'excitation du plasma (effet de pulvérisation cathodique).

De plus, la vitesse d'oxydation reste dans tous les cas relativement faible et ce dispositif ne permet de traiter qu'une seule plaquette à la fois dans sa première variante. La deuxième variante est bien une version multiplaquettes, mais ces dernières sont placées les unes à côté des autres dans un même plan transversal du tube.

Dans une telle disposition, l'enceinte nécessaire pour traiter les plaquettes présente un très grand diamètre et un très grand volume et il est très difficile d'assurer dans ces conditions une homogénéité suffisante du plasma et d'assurer une constance dans l'épaisseur d'oxyde : or, c'est cette très grande maîtrise de l'épaisseur d'oxyde et sa très grande qualité, ainsi que sa très grande homogénéité, qui sont visées dans un procédé d'oxydation applicable industriellement en microélectronique.

Il existe une autre méthode consistant également à créer un plasma d'oxygène dans une enceinte a l'intérieur de laquelle on place le corps métallique ou semiconducteur à oxyder, celui-ci étant relié électriquement à une source de tension positive par rapport à une cathode également immergée dans le plasma. Dans ce cas, et plus particulièrement lorsque la température de l'ensemble est assez élevée (supérieure à 400 °C), on peut obtenir des vitesses d'oxydation nettement supérieures. Cependant, malgré cet avantage il n'a jamais été possible d'agencer un dispositif garantissant une épaisseur constante d'oxyde sur toute la surface d'une plaquette et a fortiori de tout un lot de plaquettes ainsi traitées.

La présente invention a justement pour objet d'éliminer ces inconvénients en proposant un dispositif pour l'oxydation ou la nitruration en surface de corps solides qui permet d'obtenir à la fois une vitesse de croissance de la couche d'oxyde ou de nitrure importante, et donc une bonne rentabilité, ainsi qu'une bonne homogénéité de la couche d'oxyde ainsi obtenue.

Plus précisément, l'invention concerne un dispositif pour la réalisation de couches diélectriques minces à la surface d'au moins un corps solide, du type comportant un tube parcouru par un courant de gaz réactif et contenant le corps à traiter, des moyens de création d'un plasma à l'intérieur du tube, des moyens de chauffage de la zone du tube où se trouve le corps à traiter, ce dernier étant porté à un potentiel électrique de polarité opposée à celle des ions du plasma par rapport à celui d'une électrode se trouvant également à l'intérieur du tube.

Selon l'invention, les moyens de création du plasma se trouvent à une extrémité du tube, définissant ainsi une zone de création de plasma, la zone où se trouve le corps à traiter est séparée de la zone de création de plasma par un espace intermédiaire dimensionné de façon à prévenir la pollution du corps à traiter par des particules générées par pulvérisation cathodique dans la zone de création du plasma, et l'électrode se trouve du côté opposé à la zone de création de plasma par rapport au corps à traiter.

Si l'on désire réaliser une oxydation, le tube est parcouru par un courant d'oxygène et le corps à traiter est porté à un potentiel électrique positif par rapport à celui de ladite électrode. Si l'on désire réaliser une nitruration, le tube est parcouru par un courant d'azote et le corps à traiter est porté à un potentiel électrique négatif par rapport à celui de ladite électrode.

Dans le mode de réalisation préféré, le tube est en quartz ou en un autre matériau non oxydable et le rapport de sa longueur totale à son diamètre est compris entre 10 et 30 tandis que la longueur de la zone intermédiaire séparant la zone de création du plasma et la zone où se trouve le corps à oxyder est comprise entre 0,5 fois et 2 fois le diamètre du tube.

Le principe de l'invention, consistant à assister thermiquement par un chauffage extérieur la réaction chimique, présente les avantages suivants :

- augmenter la vitesse de croissance de la couche d'oxyde en activant thermiquement la réaction d'oxydation, et

- éviter les claquages électriques destructifs de la couche d'oxyde en minimisant les effets de charges de l'oxyde pendant la croissance, ce qui permet d'atteindre des épaisseurs élevées d'oxydes (supérieures à 1 micron).

L'invention apparaîtra mieux à la lecture de la description qui va suivre d'un exemple de réalisation pour un traitement d'oxydation, description donnée à titre purement illustratif et nullement limitatif, en référence aux dessins annexés, dans lesquels :

- la figure 1 est une vue schématique en coupe d'un dispositif conforme à l'invention,

- la figure 2 est un graphe représentant l'épaisseur d'oxyde en nanomètres en fonction du temps d'oxydation en heures avec le dispositif de l'invention comparé à un procédé thermique classique pour différentes conditions expérimentales,

- la figure 3 est un graphe représentant l'épaisseur d'oxyde en nanomètres en fonction de la durée d'oxydation en heures avec le dispositif de l'invention à différentes températures et avec une densité de courant de 10 mA/cm², et

- la figure 4 est un graphe semblable à la figure 3 lorsque la densité de courant est de 30 mA/cm².

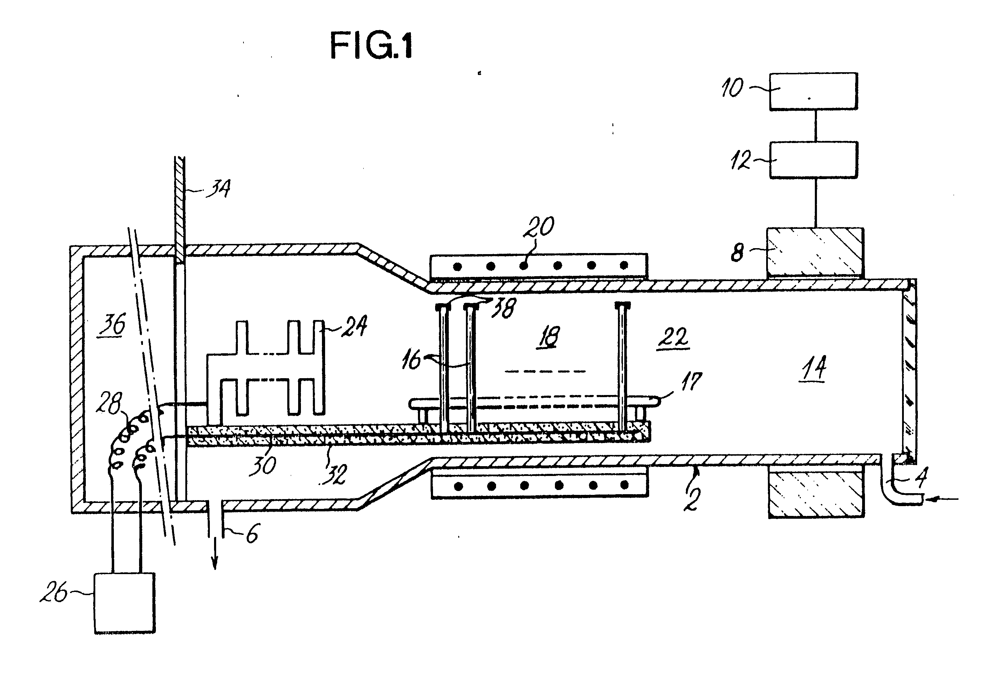

Si l'on se reporte à la figure 1, on voit que le dispositif de l'invention se compose essentiellement d'un tube de quartz 2 parcouru par un courant d'oxygène, le gaz pénétrant par un piquage 4 situé à une extrémité du tube et sortant par un autre piquage 6 situé à l'autre extrémité du tube 2.

Selon l'invention, le tube est équipé au voisinage de son extrémité par où arrive l'oxygène de moyens de création de plasma qui peuvent consister par exemple en une électrode capacitive 8 reliée à un générateur haute fréquence 10 par l'intermédiaire d'une boîte d'accord 12. On définit ainsi à l'extrémité du tube une zone 14 qu'on appellera « zone de création de plasma » dans la suite du présent texte. De manière connue, les corps à oxyder, par exemple des plaquettes de silicium 16, sont placées sur un support 17 dans une zone 18 du tube qui est chauffée par des moyens extérieurs, par exemple une résistance électrique 20. Lorsqu'on traite tout un lot de plaquettes, celles-ci sont disposées de préférence parallèlement entre elles et perpendiculairement à l'axe longitudinal du tube.

Selon l'invention, la zone 18 dans laquelle se trouvent les plaquettes 16 est séparée de la zone 14 d'excitation du plasma par une zone intermédiaire 22 dont la longueur est comprise entre 0,5 et 2 fois le diamètre du tube 2 : l'homme de l'art déterminera cette distance en fonction de chaque cas particulier en sachant qu'elle doit être directement fonction du libre parcours des particules issues par pulvérisation du tube dans la zone de création du plasma. Ceci permet d'assurer l'absence de pulvérisation cathodique du tube et d'obtenir une très bonne qualité de l'oxyde puisque les plaquettes ne risquent pas d'être polluées par des particules de quartz arrachées au tube.

La figure 1 montre encore que le dispositif comporte une cathode 24 placée à l'intérieur du tube 2 mais du côté opposé à la zone de création de plasma 14 par rapport à la zone centrale 18 où se trouvent les plaquettes 16, c'est-à-dire en aval de ces dernières par rapport au sens du courant d'oxygène. La cathode 24 est reliée au moyen d'un fil 28 à un générateur de tension 26 auquel sont également reliées les plaquettes 16 par l'intermédiaire d'un fil 30 protégé par une gaine d'isolation 32. Le générateur 26 est réglé de telle sorte que le potentiel des plaquettes 16 soit positif par rapport à celui de la cathode 24.

Cette dernière doit présenter une surface de contact avec le plasma compatible avec l'intensité de courant d'anodisation, ce courant étant d'autant plus important (pour une vitesse d'oxydation donnée) que la surface totale des plaquettes traitées simultanément est grande. Ceci explique la forme compliquée donnée à la cathode dans l'exemple de la figure 1, mais on ne sortirait pas du cadre de l'invention en utilisant d'autres formes pour la cathode.

Le fait d'utiliser un montage anode-cathode permet d'obtenir une plus grande vitesse de croissance de l'oxyde. D'autre part, lorsque, conformément à l'invention, on éloigne la zone de cathode de la zone de création et d'excitation du plasma et lorsque la cathode est placée en aval des plaquettes à oxyder par rapport à cette zone, les lignes de champ de polarisation des plaquettes ne sont pas perturbées par les champs électriques intenses régnant dans la zone de création du plasma, ce qui permet d'assurer une croissance d'oxyde parfaitement uniforme sur toute la surface de la plaquette et sur chaque plaquette traitée simultanément si on traite un lot de plaquettes.

On voit encore sur la figure que l'on peut avantageusement prévoir une vanne d'isolement 34 du tube 2 et un sas de chargement 36 situé en aval de cette dernière par rapport au courant d'oxygène. Cette disposition permet d'introduire dans le sas l'ensemble constitué par les plaquettes 16, leur support 17, la gaine 32 et la cathode 24, puis de faire le vide dans le sas de chargement avant de disposer les plaquettes et la cathode à leur emplacement définitif. Ce système de sas permet de protéger le tube d'éventuelles pollutions extérieures.

D'autre part, dans le cas particulier représenté ici, les plaquettes sont traitées par groupes de deux accollées dos à dos, les plaquettes d'un groupe donné étant réunies à leur partie supérieure par des agrafes 38. Il est possible avec un tel dispositif de réaliser l'oxydation des plaquettes soit sur les deux faces, soit sur une seule face en protégeant l'autre avec un matériau isolant. Le contact entre le matériau isolant et la plaquette n'a pas besoin d'être parfait car, en deçà de quelques dixièmes de millimètres d'épaisseur d'interstice, le plasma ne peut pénétrer entre la plaquette et l'isolant.

A titre d'essai, on a réalisé avec un tel dispositif l'oxydation de plaquettes de silicium d'un diamètre de 10 cm environ. On a constaté que les meilleurs résultats étaient obtenus en opérant à une pression comprise entre 1,35 et 13,5 Pa (entre 10 et 100 mTorr), de préférence comprise entre 2,7 et 6,75 Pa (entre 20 et 50 mTorr), et avec un débit d'oxygène compris entre 1 et 20 cm$^3$/minute. La température est comprise entre 300 et 900 °C et de préférence entre 500 et 800 °C. La densité de courant d'anodisation, c'est-à-dire la densité du courant traversant les plaquettes, est comprise entre 10 et 30 mA/cm$^2$ pour une tension appliquée entre l'anode et la cathode comprise entre 50 et 250 volts. Quant à la fréquence d'excitation du plasma, elle peut varier entre 0,5 et 30 MHz, la fréquence préférée étant de 13,56 MHz.

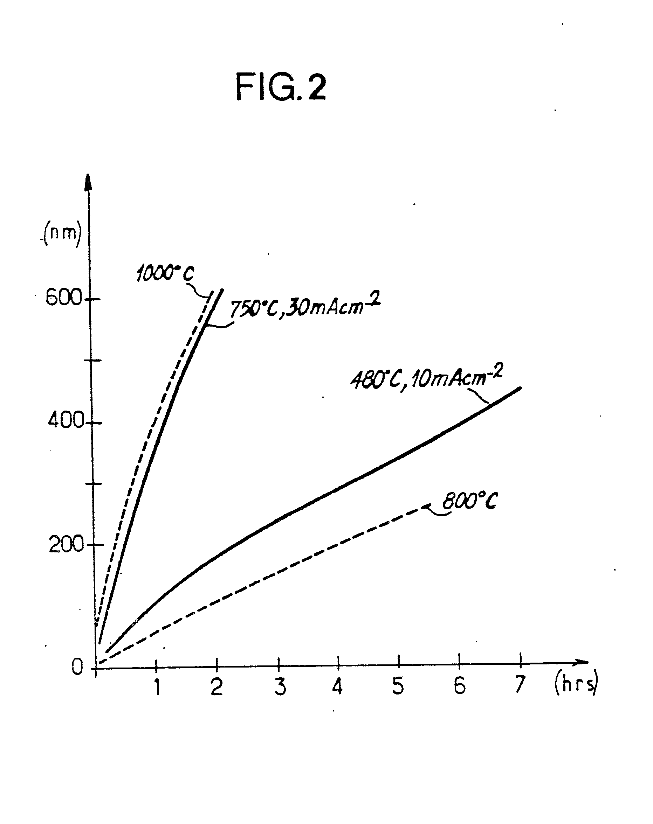

Les courbes de la figure 2 représentent l'épaisseur d'oxyde obtenue en fonction de la durée d'oxydation avec le dispositif de l'invention (courbes en traits pleins) et avec un procédé thermique classique (courbes en traits interrompus) sur des plaquettes de silicium. On voit qu'en travaillant à 480 °C avec une densité de courant de 10 mA/cm$^2$, on obtient une vitesse d'oxydation supérieure à celle qu'on obtient à 800 °C avec le procédé thermique.

D'autre part, la courbe obtenue avec le dispositif de l'invention à 750 °C avec une densité de courant de 30 mA/cm$^2$ est pratiquement confondue avec la courbe correspondant à une oxydation thermique effectuée à 1000 °C.

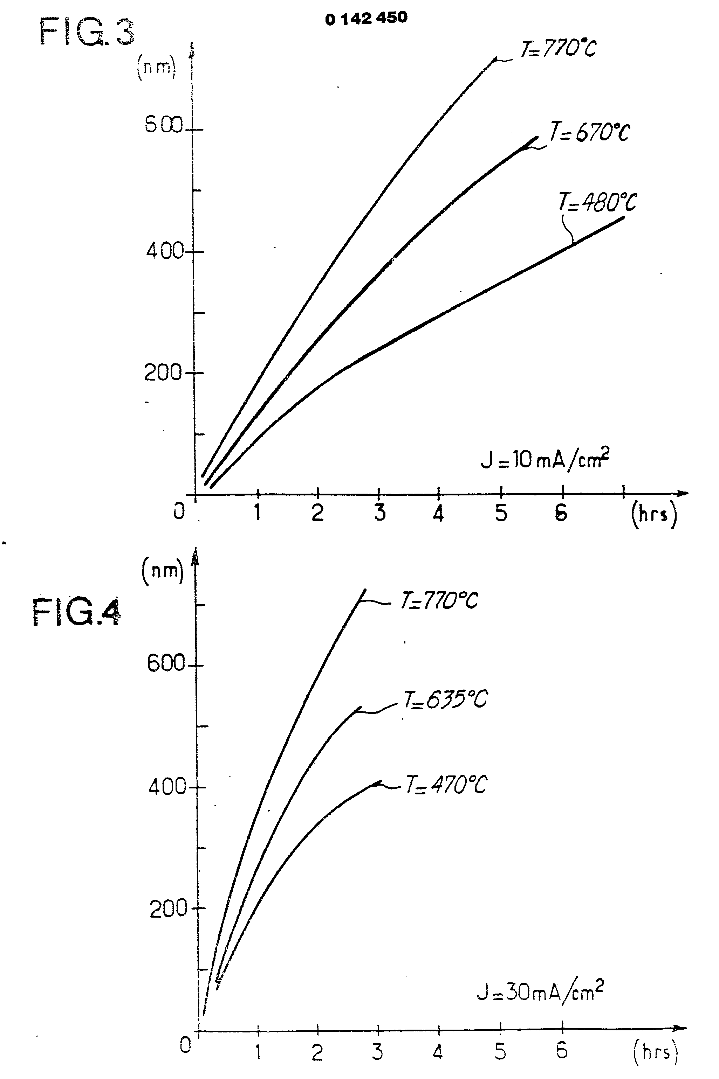

Quant aux figures 3 et 4, elles montrent l'épaisseur d'oxyde obtenue en fonction du temps d'oxydation pour différentes températures, les courbes de la figure 3 correspondant à une densité de courant J de 10 mA/cm$^2$ et la figure 4 correspondant à une densité de courant J de 30 mA/cm$^2$. On voit par exemple (figure 3) qu'au bout de deux heures l'épaisseur d'oxyde est de l'ordre de 180 nanomètres si l'on opère à 480 °C et de l'ordre de 350 nanomètres si l'on opère a 770 °C avec une densité de courant de 10 mA/cm$^2$. La comparaison avec la figure 4 montre que si l'on opère avec une densité de courant de 30 mA/cm$^2$, ces valeurs passent respectivement à 350 et 600 nanomètres environ.

Ainsi le dispositif objet de l'invention présente de nombreux avantages dont le principal est d'obtenir une croissance rapide de la couche d'oxyde grâce au fait que la température est maintenue suffisamment élevée par le chauffage extérieur, une bonne homogénéité grâce au fait que la zone où se trouvent les plaquettes à oxyder est éloignée de la zone de création du plasma et on ne risque pas de polluer les plaquettes par la projection de particules de quartz arrachées au tube dans la zone de création de plasma. De plus, on peut aisément contrôler la vitesse d'oxydation ainsi que l'épaisseur d'oxyde en fin de traitement en mesurant et contrôlant soit l'intensité du courant d'anodisation si l'on travaille à tension constante, soit la tension d'anodisation si l'on travaille à courant constant.

Des épaisseurs élevées peuvent être obtenues sans claquages électriques du fait que le champ électrique dans l'oxyde est minimisé par la possibilité offerte par le système de réaliser l'anodisation à une température suffisamment élevée.

Bien entendu, l'invention peut être utilisée pour réaliser localement sur une plaquette des couches minces diélectriques : il suffit pour cela de disposer sur la plaquette un masque définissant les zones à traiter. Le dispositif décrit dans la présente invention n'est pas applicable exclusivement à l'oxydation de matériaux semiconducteurs. Il peut aussi servir, sans pratiquement aucune modification de structure, à la nitruration de matériaux semiconducteurs. Dans ce cas, il suffit de remplacer l'oxygène circulant dans le tube par de l'azote, et d'inverser les polarisations des plaquettes et de la cathode (qui devient ainsi une anode). Dans le cas d'une utilisation en nitruration, on constate que l'ensemble des avantages annoncés pour l'oxydation restent valables. Le même four comportant les dispositions conformes à l'invention peut par conséquent servir indifféremment à l'oxydation ou à la nitruration.

Enfin, il est bien entendu que l'invention ne se limite pas au seul mode de réalisation qui vient d'être décrit mais qu'on peut envisager des variantes sans sortir pour autant du cadre de l'invention. C'est ainsi que l'homme de l'art pourra faire varier en fonction de chaque cas particulier les moyens de création du plasma ou de chauffage de la zone où se trouvent les plaquettes à traiter ou la forme de l'électrode. Par exemple, dans le cas de réalisation illustré à la figure 1, toutes les plaquettes traitées simultanément peuvent être reliées électriquement à une seule source de tension. Cependant, il peut être préférable de relier individuellement chaque plaquette à une source électrique séparée ou de relier individuellement des petits groupes de plaquettes à une même source. On peut ainsi mieux contrôler le courant traversant chaque plaquette d'un même lot afin de s'assurer de l'uniformité de l'épaisseur d'oxyde formé sur toutes les plaquettes d'un même lot.

**Revendications**

1. Dispositif pour la réalisation de couches diélectriques minces à la surface d'au moins un corps solide (16), du type comportant un tube (2) parcouru par un courant de gaz réactif et contenant le corps à traiter (16), des moyens de création d'un plasma à l'intérieur du tube (2), des moyens de chauffage de la zone du tube où se trouve le corps à traiter (16), ce dernier étant porté à un potentiel électrique de polarité opposée à celle des ions du plasma par rapport à celui d'une électrode (24) se trouvant également à l'intérieur du tube (2), caractérisé en ce que les moyens de création du plasma se trouvent à une extrémité du tube, définissant ainsi une zone de création de plasma (14), en ce que la zone où se trouve le corps à traiter (16) est séparée de la zone de création de plasma (14) par un espace intermédiaire (22) dimensionné de façon à prévenir la pollution du corps à traiter (16) par des particules générées par pulvérisation cathodique dans la zone de création du plasma (14) et en ce que l'électrode (24) se trouve du côté opposé à la zone de création de plasma (14) par rapport au corps à traiter (16).

2. Dispositif selon la revendication 1, caractérisé en ce que ledit tube (2) est parcouru par un courant d'oxygène et en ce que le corps à traiter (16) est porté à un potentiel électrique positif par rapport à celui de ladite électrode (24).

3. Dispositif selon la revendication 1, caractérisé en ce que ledit tube (2) est parcouru par un courant d'azote et en ce que le corps à traiter (16) est porté à un potentiel électrique négatif par rapport à celui de ladite électrode (24).

4. Dispositif selon l'une quelconque des revendications 1 à 3, caractérisé en ce que ledit tube (2) est réalisé en un matériau non oxydable.

5. Dispositif selon la revendication 4, caractérisé en ce que ledit tube (2) est un tube de quartz.

6. Dispositif selon l'une quelconque des revendications 1 à 5, caractérisé en ce que le rapport de la longueur totale du tube (2) à son diamètre est compris entre 10 et 30.

7. Dispositif selon l'une quelconque des revendications 1 à 6, caractérisé en ce que la longueur de la zone intermédiaire (22) entre la zone de création de plasma (14) et la zone où se trouve le corps à oxyder (16) est comprise entre 0,5 fois et 2 fois le diamètre du tube.

## Claims

1. Device for forming thin dielectric layers at the surface of at least one solid body (16), of the type comprising a tube (2) through which a current of reactive gas flows and which contains the body to be treated (16), means for generating a plasma within the tube (2), means for heating the zone of the tube in which the body to be treated (16) is situated, the latter being brought to an electrical potential of polarity opposite to that of the ions of the plasma in relation to that of an electrode (24) likewise situated within the tube (2), characterized in that the means for generating the plasma are situated at one end of the tube, thus defining a plasma generation zone (14), in that the zone in which the body to be treated (16) is situated is separated from the plasma generation zone (14) by an intermediate space (22) dimensioned in such a manner as to prevent the contamination of the body to be treated (16) by particles generated by cathode sputtering in the zone of generation of the plasma (14), and in that the electrode (24) is situated on the side opposite to the plasma generation zone (14) in relation to the body to be treated (16).

2. Device according to Claim 1, characterized in that a current of oxygen flows through the said tube (2), and in that the body to be treated (16) is brought to an electrical potential which is positive in relation to that of the said electrode (24).

3. Device according to Claim 1, characterized in that a current of nitrogen flows through the said tube (2), and in that the body to be treated (16) is brought to an electrical potential which is negative in relation to that of the said electrode (24).

4. Device according to any one of Claims 1 to 3, characterized in that the said tube (2) is formed of a non-oxidizable material.

5. Device according to Claim 4, characterized in that the said tube (2) is a quartz tube.

6. Device according to any one of Claims 1 to 5, characterized in that the ratio of the total length of the tube (2) to its diameter is within the range between 10 and 30.

7. Device according to any one of Claims 1 to 6, characterized in that the length of the intermediate zone (22) between the plasma generation zone (14) and the zone in which the body to be oxidized (16) is situated is within the range between 0.5 times and 2 times the diameter of the tube.

## Patentansprüche

1. Vorrichtung zur Herstellung von dünnen, dielektrischen Schichten auf der Oberfläche von wenigstens einem festen Körper (16) von der Art, welche eine von einem Strom reaktiven Gases durchströmte und den zu behandelnden Körper (16) enthaltende Röhre (2), Mittel zum Erzeugen eines Plasmas im Inneren der Röhre (2) und Mittel zum Heizen der Zone der Röhre aufweist, wo sich der zu behandelnde Körper befindet, wobei dieser Letztere auf ein elektrisches Potential, dessen Polarität zu demjenigen der Ionen des Plasmas entgegengesetzt ist, in bezug auf dasjenige einer Elektrode (24) gebracht wird, die sich ebenfalls im Inneren der Röhre (2) befindet, dadurch gekennzeichnet, daß sich die Mittel zum Erzeugen des Plasmas an einem Röhrenende befinden, wobei sie somit eine Zone (14) zur Erzeugung des Plasmas festlegen, daß die Zone, wo sich der zu behandelnde Körper (16) befindet, von der Zone (14) zur Erzeugung des Plasmas durch einen Zwischenraum (22) getrennt ist, der so bemessen ist, daß eine Verunreinigung des zu behandelnden Körpers (16) mit durch Kathodenzerstäubung in der Zone (14) zur Erzeugung des Plasmas erzeugten Teilchen verhindert wird, und daß sich die Elektrode (24) auf der zu der Zone zur Erzeugung des Plasmas in bezug auf den zu behandelnden Körper (16) entgegengesetzten Seite befindet.

2. Vorrichtung nach Anspruch 1, dadurch gekennzeichnet, daß die genannte Röhre (2) von einer Sauerstoffströmung durchströmt wird und daß der zu behandelnde Körper (16) auf ein positives, elektrisches Potential in bezug auf dasjenige der genannten Elektrode (24) gebracht wird.

3. Vorrichtung nach Anspruch 1, dadurch gekennzeichnet, daß die genannte Röhre (2) von einer Stickstoffströmung durchströmt wird und daß der zu behandelnde Körper (16) auf ein negatives, elektrisches Potential in bezug auf dasjenige der genannten Elektrode (24) gebracht wird.

4. Vorrichtung nach irgendeinem der Ansprüche 1 bis 3, dadurch gekennzeichnet, daß die genannte Röhre (2) aus einem nichtoxidierbaren Material hergestellt ist.

5. Vorrichtung nach Anspruch 4, dadurch gekennzeichnet, daß die genannte Röhre (2) eine Quarzröhre ist.

6. Vorrichtung nach irgendeinem der Ansprüche 1 bis 5, dadurch gekennzeichnet, daß das Verhältnis der Gesamtlänge der Röhre (2) zu ihrem Durchmesser zwischen 10 und 30 liegt.

7. Vorrichtung nach irgendeinem der Ansprüche 1 bis 6, dadurch gekennzeichnet, daß die Länge des Zwischenraums (22) zwischen der Zone (14) zur Erzeugung des Plasmas und der Zone, wo sich der zu behandelnde Körper (16) befindet, zwischen dem 0,5-fachen und dem 2-fachen des Röhrendurchmessers liegt.

# FIG.1

0 142 450

# FIG. 2

FIG.3

FIG.4